# EUROPÄISCHE PATENTSCHRIFT

(11) **EP 0 381 985 B1**
(45) Veröffentlichungstag und Bekanntmachung des Hinweises auf die Patenterteilung: **20.04.1994**
(21) Anmeldenummer: 90101252.6
(22) Anmeldetag: 23.01.1990
(51) Int. Cl.: B41F 17/22, B41F 27/12

(54) **Verfahren zum Bedrucken von nicht-saugfähigen Materialien und Druckplatte zur Durchführung desselben**
Method for printing non-absorbing materials and printing plate for realizing the method
Procédé pour imprimer des matériaux non absorbants et cliché pour la réalisation dudit procédé

(30) Priorität: 09.02.1989 DE 3903806
(43) Veröffentlichungstag der Anmeldung: 16.08.1990
(73) Patentinhaber: Höll, Dieter, Dr., D-40667 Meerbusch (DE)
(72) Erfinder: Höll, Dieter, Dr., D-40667 Meerbusch (DE)
(74) Vertreter: Werner, Hans-Karsten, Dr.Dipl.-Chem.

(56) Entgegenhaltungen:
- EP-A- 0 081 443
- FR-A- 838 127
- GB-A- 2 109 306

## Beschreibung

Gegenstand der vorliegenden Erfindung ist ein Verfahren zum Bedrucken von nicht-saugfähigen Materialien, insbesondere runden Hohlkörpern, im Hochdruckverfahren mit mehreren Farben unter Verwendung von mehreren Farbwerken mit auf den Klischeezylindern aufgespannten positionierbaren Druckplatten, bei denen die Druckplatten auf den Klischeezylindern aufgespannt sind mittels zwei Reihen von Zylinderstiften und entsprechenden Reihen von Löchern an zwei Rändern der Druckplatten. Weiterhin betrifft die Erfindung Druckplatten zur Durchführung dieses Verfahrens.

Das Bedrucken von nicht-saugfähigen Materialien, insbesondere Metall oder Kunststoff, erfolgt auch heute noch weitgehend im Hochdruckverfahren, da die Offsetverfahren im allgemeinen eine gewisse Saugfähigkeit des zu bedrukkenden Materials erfordern und die Offset-Druckwerke einen höheren Raumbedarf haben. Von besonderer Bedeutung ist das Bedrucken von runden Hohlkörpern, wie Tuben, Dosen, nahtlosen Bechern, Kunststoffhülsen etc., die sowohl zylindrisch als auch konisch sein können. Im Hochdruckverfahren werden aber auch nicht-saugfähige Kunststoffbahnen bedruckt. Sofern das zu bedruckende Material eine ausreichende Elastizität besitzt, kann das direkte Hochdruckverfahren zur Anwendung kommen, d.h., das an der Farbwalze eingefärbte Klischee wird zum direkten Bedrucken des Materials verwendet. Sollen mehrere Farben im direkten Hochdruckverfahren aufgebracht werden, muß jedoch die Farbe beispielsweise durch UV-Licht getrocknet werden, bevor das nächste Teilbild gedruckt werden kann. Beim Bedrucken von nicht-elastischem und nicht-saugfähigem Material, und insbesondere bei runden Hohlkörpern, kommt überwiegend das indirekte Hochdruckverfahren zur Anwendung, d.h., das eingefärbte Klischee gibt seine Farbe an ein Gummituch ab und das Gummituch gibt die Farbe im nächsten Arbeitsgang an die zu bedruckende Fläche ab. Beim indirekten Mehrfarbendruck gibt nacheinander jedes Farbwerk über sein Klischee seine Farbe an das Gummituch ab, welches im nächsten Arbeitsschritt sämtliche Farben auf einmal an das zu bedruckende Material abgibt. Dieses Verfahren macht es erforderlich, daß die Farbklischees nicht nur passergenau sind, sondern auch sehr genau auf der Klischeewalze positioniert sind. Da sämtliche Farben im nassen Zustand nebeneinander auf dem Gummituch vorhanden sind, darf es zu keinerlei unerwünschten Überlappungen kommen, da dies zum Verschmieren der Farben führt. Es dürfen aber auch keine unerwünschten Spalten zwischen zwei Farbflächen vorhanden sein, da dies zu unschönen "Blitzern" führt. Diese "Blitzer" stören insbesondere dadurch, daß das Bedrucken meist auf einem hellen Grundlack erfolgt, der dann sehr deutlich zu erkennen ist.

Um einwandfrei bedruckte Produkte zu erhalten, ist es somit notwendig, die passergenauen Teilbilder sehr genau zu positionieren, so daß es nicht zu den unerwünschten Überlappungen, Verschmierungen und/oder "Blitzern" kommt. Dieses Positionieren erfolgt bisher in der Weise, daß die Klischees außerhalb der Druckmaschine in einer Klischee-Einspannvorrichtung auf die Wechselklischeezylinder aufgespannt werden. Mit Hilfe von Zentriermikroskopen werden sie zunächst auf die Fadenkreuze der Klischees eingestellt. Diese Fadenkreuze sind jedoch bei Hochdruckplatten aus technischen Gründen viel zu groß und viel zu grob, um reproduzierbar die richtige Position zu finden. Hochdruckplatten benötigen für einen Strich oder Punkt eine größere Mindestbreite am Sockel des Klischees. Das Klischeematerial besteht meist aus Nylon oder anderen transparenten Kunststoffen, so daß die Fadenkreuze aus diesem Material unter dem Mikroskop viel zu groß und zu grob erscheinen, um mit ihrer Hilfe die Druckplatte wirklich positionieren zu können. Außerdem sind die Fadenkreuze oftmals nicht exakt zu den Bildelementen positioniert, da sie erst beim Herstellen der Filme zusätzlich angebracht werden.

Das Aufspannen und Positionieren der Druckplatten auf die Klischeezylinder erfolgt daher in der Weise, daß die richtige Position abgeschätzt und dann im Probedruck überprüft wird. Korrekturen der Position können dann sowohl durch Verdrehen, diagonales Verzerren als auch paralleles Verschieben erfolgen. Das exakte aufeinander Abstimmen mehrerer Platten erfordert trotz der Voreinrichtung außerhalb der Maschine anschließend in der Maschine je nach Anzahl der Farben und der Kompliziertheit des Druckbildes zusätzlich mehrere Stunden bis zu mehr als einer Arbeitsschicht. Es handelt sich um qualifizierte Arbeit hochbezahlter Mitarbeiter, von deren Geschicklichkeit es abhängt, mit welcher Qualität die Endprodukte schließlich bedruckt werden. Da die Bedruckung von runden Hohlkörpern meist noch als Teilschritt einer größeren Productions- und/oder Abfüllanlage erfolgt, bedeutet dieses Aufspannen und Positionieren der Druckplatten Stillstand der gesamten Anlage. Insbesondere wenn auf derartigen Produktions- und/oder Abfüllanlagen häufig verschiedene Produkte hergestellt werden, ist das Umrüsten von einem Produkt auf das andere ein erheblicher Kostenfaktor.

Üblicherweise werden die Druckplatten hergestellt aus handelsüblichen, vorgefertigten Klischeeplatten, bestehend aus einer photopolymerisierbaren Polymerschicht auf einem Metallträger oder einem formbeständigen Trägerfilm (z.B. Nylon Print). Die fertigen Druckplatten werden oftmals noch mit Spannschlitzen auf den Klischeezylindern befestigt und danach positioniert, wobei die Fadenkreuze auf dem Klischee nur zur groben Vororientierung dienen. Es sind auch schon Druckplatten in der Weise auf Klischeezylinder aufgespannt worden, daß man auf den Klischeezylindern zwei Reihen von Zylinderstiften angebracht hat und in die vorher fertiggestellten Druckplatten nachträglich an zwei Rändern entsprechende Reihen von Löchern gebohrt wurden. Die Druckplatten wurden dann in die Reihen von Zylinderstiften eingehängt und mit Spannschrauben oder Spannfedern gespannt. Die so aufgespannten Druckplatten wurden jedoch wiederum in üblicher Weise innerhalb der Maschine und durch Probedruck auf die richtige Position hin überprüft. Diese Art des Aufspannens hat somit keine wesentlichen Vorteile bezüglich der Positionierung gegeben.

Die GB-A-2 109 306 beschreibt ein Verfahren bei welchem zwar die aufgespannten positionierbaren Druckplatten mittels Stiften und entsprechenden Löchern an zwei Rändern der Druckplatten aufgespannt werden und bei dem die Löcher in den Rändern schon vor der Herstellung der Teilbilder in den Rändern der noch unbelichteten Druckplatten angebracht werden, jedoch verlangt das dort beschriebene Verfahren, daß das auf ihn enthaltene Druckbild zu den Löchern richtig positioniert ist. Diese richtige Positionierung ist selbst dann nicht zwangsläufig der Fall, wenn die Druckplatte vor der Belichtung entsprechend gelocht und aufgespannt wird. Es kann nämlich noch immer das belichtete Druckbild nach allen Seiten hin versetzt sein. Das Verfahren nach dem Stand der Technik verlangt daher ein sehr exaktes Ausrichten der Negative beim Aufkleben bzw. eine Kamera, die ein Stift-Registrier-System hat; vergl. Spalte 2, Zeilen 89 bis 94. Sofern dieser Schritt nicht mit äußerster Präzision erfolgt, ist sogar hinterher eine Korrektur nicht mehr möglich, da die Negative gelocht sind. Wahrscheinlich ist dies auch der Grund dafür, warum sich das Verfahren nach diesem Stand der Technik nicht bewährt hat.

Die Erfindung hat sich die Aufgabe gestellt, die Umrüstzeiten von den oben beschriebenen Druckwerken zu verkürzen und das Aufspannen und Positionieren der Druckplatten zu vereinfachen.

Es wurde jetzt gefunden, daß es möglich ist, diese Aufgabe dadurch zu lösen und sogar auf die nachträgliche Positionierung der Druckplatten zueinander in der Maschine völlig zu verzichten, indem sowohl die Reihen von Zylinderstiften als auch die entsprechenden Reihen von Löchern an den Rändern der Druckplatten bezüglich Größe und Position eine Präzision im 10µ-Bereich aufweisen, und auch die passergenauen Teilbilder der verschiedenen Druckplatten bezogen auf die Reihen von Löchern an den Rändern im 10µ-Bereich genau gleich positioniert sind, wobei die Reihen von Löchern in den Rändern der noch unbelichteten Druckplatten schon vor der Herstellung der Teilbilder angebracht werden und bereits während der Herstellung der Teilbilder zu deren exakten Positionierung dienen, wobei bei der Herstellung der Teilbilder alle Arbeitsschritte vom erstmaligen Ausrichten des Negativs der Reinzeichnung über die Herstellung der Teilnegative bis zur Herstellung der Druckplatte in Rahmen erfolgen, die ebenfalls im 10µ-Bereich exakt positionierte Reihen von Zylinderstiften aufweisen und zur Aufnahme aller vorher exakt und entsprechend gelochten Materialien dienen.

Die Fachleute auf diesem Gebiet haben diesen Lösungsweg zunächst für nicht gangbar gehalten, da man es für unmöglich oder viel zu aufwendig gehalten hat, ganze Serien von Leisten mit Zylinderstiften einerseits und Reihen von Löchern an den Rändern der Druckplatten andererseits so präzise herstellen zu können, daß die Abweichungen bezüglich Größe und Position nur noch im 10µ-Bereich liegen. Tatsächlich ist dies auch erst in den Bereich des technisch Möglichen und wirtschaftlich Vertretbaren gekommen durch die inzwischen zur Verfügung stehenden elektronisch gesteuerten Werkzeugmaschinen, die reproduzierbar größere Serien derartiger Präzisionsteile anfertigen können. Weiterhin bedurfte es der Entwicklung und Herstellung von neuen Werkzeugen und Hilfsmitteln, um bei der Herstellung der passergenauen Teilbilder verschiedener Druckplatten, diese bezogen auf die Reihen von Löchern an den Rändern im 10µ-Bereich genau gleich positionieren zu können.

Die Herstellung der Druckplatten erfolgt dadurch, daß bei der Herstellung der Teilbilder alle Arbeitsschritte vom erstmaligen Ausrichten des Negativs der Reinzeichnung über die Herstellung der Teilnegative bis zur Herstellung der Druckplatte in Rahmen erfolgen, die ebenfalls im 10µ-Bereich exakt positionierte Reihen von Zylinderstiften aufweisen und zur Aufnahme aller vorher exakt und entsprechend gelochten Materialien dienen.

Es werden bereits präzise vorgelochte unbelichtete Klischeeplatten, Folien, Masken, Millimeterfolien und Rahmen mit entsprechend präzisen Zylinderstiften etc. verwendet. Die Anbringung der Reihen von Löchern in den Druckplatten und Hilfsmitteln erfolgt vorzugsweise mit Hilfe von Präzisionsstanzen.

Die Herstellung der erfindungsgemäß verwendeten Druckplatten ist somit zunächst einmal wesentlich aufwendiger und bedeutet eine völlige Umstellung der Arbeitsweise bei der Herstellung der Klischees. Dieser erhöhte Aufwand fällt aber insgesamt kaum mehr ins Gewicht, wenn man ihn mit den Kosten für das Aufspannen und Positionieren der Druckwalzen im herkömmlichen Verfahren vergleicht, insbesondere wenn wegen Produktumstellung häufiger umgerüstet werden muß.

Völlig zu vernachlässigen sind diese Mehrkosten für die Druckplatten, wenn hierdurch die Stillstandszeiten von Produktions- und Abfüllanlagen verkürzt werden können. Diese Zeiten können erfindungsgemäß so drastisch verkürzt werden, da sich überraschenderweise herausgestellt hat, daß das Positionieren ganz entfallen kann oder nur noch geringfügig in radialer oder axialer Richtung nötig ist. Beim erfindungsgemäßen Verfahren werden vor allem schiefe Positionen völlig vermieden. Parallele Verschiebungen sind meist nur noch in einer Richtung, und das im ganz geringen Maße notwendig. Die Umrüstzeiten bei einem komplizierteren Sechsfarbendruck auf einer Spraydose konnten durch das erfindungsgemäße Verfahren von 8 bis 10 Stunden auf 0,5 bis 2 Stunden reduziert werden. Umrüstzeiten bei einer Tube mit Vierfarbendruck konnten von 5 bis 6 Stunden auf weniger als eine Stunde reduziert werden. Sowohl Spraydosen als auch Tuben werden im allgemeinen vom Rohling bis zu den verpackten/pallettisierten Dosen und Tuben in einer Produktionsstraße hergestellt. Es gibt inzwischen Produktions- und Abfüllanlagen in denen bereits die Dosen, Tuben, Kunststoffbecher etc. unmittelbar befüllt und verpackt werden. Stillstands- und Umrüstzeiten sind in derartigen Anlagen ein bedeutender Kostenfaktor.

Gegenstand der vorliegenden Erfindung ist somit nicht nur das Verfahren zum Bedrucken, sondern auch das Bedrucken als Teilschritt einer Produktions- und/oder Abfüllanlage. Ein weiterer Gegenstand der Erfindung sind die Druckplatten zur Durchführung des Verfahrens, die dadurch gekennzeichnet sind, daß sie an beiden Rändern Reihen von Löchern aufweisen, die bezüglich Größe und Position eine Präzision im 10µ-Bereich aufweisen und die passergenauen Teilbilder bezogen auf die Reihen von Löchern an den Rändern im 10µ-Bereich genau positioniert sind, indem bereits die unbelichteten Druckplatten schon vor der Herstellung der Teilbilder mit Löchern an den Rändern versehen wurden, die bezüglich Größe und Position eine Präzision im 10µ-Bereich aufweisen.

Die Durchführung des erfindungsgemäßen Verfahrens wird im folgenden Beispiel ausführlicher beschrieben:
Zuerst wird die Aufnahme der Reinzeichnung mit der Reproduktionskamera zum Negativ gemacht. Dieses Negativ wird präzise auf eine durch eine Spezialstanze gelochte Maske gesetzt. Das präzise Ausrichten des Negativs ist durch eine ebenfalls auf derselben Stanze gelochte Millimeterfolie möglich. Die Maske wird sodann auf einen Spezialrahmen aus Aluminium gelegt, der mit Paßstiften versehen ist, welche in ihren Maßen und in ihrer Positionierung mit den gestanzten Lochstreifen im 10µ-Bereich übereinstimmen. Damit ist gewährleistet, daß die Lochstreifen der Maske präzise parallel zu den Achsen des Bildes verlaufen. Von nun an werden alle weiteren Arbeitsgänge, einschließlich Belichten der Endnegative für die einzelnen Farbteile des Gesamtbildes mit gelochtem Folienmaterial auf demselben Rahmen durchgeführt. Damit ist gewährleistet, daß die Lochstreifen der einzelnen Endnegative präzise zu den Achsen des einzelnen Farbteilbildes und des Gesamtbildes verlaufen. Schließlich wird jedes Endnegativ auf eine mit derselben Spezialstanze gelochte Klischeeplatte in denselben Arbeitsrahmen gelegt und dann die Klischeeplatte belichtet. Damit ist gewährleistet, daß auch die Lochstreifen der einzelnen Klischees präzise zu den Achsen des einzelnen Teilbildes und damit des Gesamtbildes verlaufen.

Die fertig entwickelten Druckplatten werden auf die Klischeezylinder aufgespannt, welche mit Paßstiften versehen sind, welche wiederum in ihren Maßen und in ihrer Positionierung mit den gestanzten Lochstreifen im 10µ-Bereich übereinstimmen.

Die Zylinder müssen nur einmalig in der Maschine exakt auf Nullstellung einjustiert sein, dann steht das Bild nach dem Einspannen. Nur gelegentlich sind parallele Verschiebungen im axialen oder radialen Bereich von 0,1 mm erforderlich, während schiefe Positionen nicht mehr beobachtet wurden.

## Patentansprüche

1. Verfahren zum Bedrucken von nicht-saugfähigen Materialien, insbesondere runden Hohlkörpern, im Hochdruckverfahren mit mehreren Farben unter Verwendung von mehreren Farbwerken mit auf den Klischeezylindern aufgespannten positionierbaren Druckplatten, bei denen die Druckplatten auf den Klischeezylindern aufgespannt sind mittels zwei Reihen von Zylinderstiften und entsprechenden Reihen von Löchern an zwei Rändern der Druckplatten, dadurch gekennzeichnet, daß sowohl die Reihen von Zylinderstiften als auch die entsprechenden Reihen von Löchern an den Rändern der Druckplatten bezüglich Größe und Position eine Präzision im 10µ-Bereich aufweisen, und auch die passergenauen Teilbilder der verschiedenen Druckplatten bezogen auf die Reihen von Löchern an den Rändern im 10µ-Bereich genau gleich positioniert sind, wobei die Reihen von Löchern in den Rändern der noch unbelichteten Druckplatten schon vor der Herstellung der Teilbilder angebracht werden und bereits während der Herstellung der Teilbilder zu deren exakten Positionierung dienen, wobei bei der Herstellung der Teilbilder alle Arbeitsschritte vom erstmaligen Ausrichten des Negativs der Reinzeichnung über die Herstellung der Teilnegative bis zur Herstellung der Druckplatte in Rahmen erfolgen, die ebenfalls im 10µ-Bereich exakt positionierte Reihen von Zylinderstiften aufweisen und zur Aufnahme aller vorher exakt und entsprechend gelochten Materialien dienen.

2. Verfahren gemäß Anspruch 1, dadurch gekennzeichnet, daß die Lochung der Druckplatten und aller zu ihrer Herstellung verwendeten Materialien durch eine Präzisionsstanze erfolgt.

3. Verfahren gemäß Anspruch 1 oder 2, dadurch gekennzeichnet, daß die Reihen von Zylinderstiften auf den Klischeezylindern und den Rahmen auf elektronisch gesteuerten Werkzeugmaschinen hergestellt werden.

4. Verfahren gemäß einem der Ansprüche 1 bis 3, dadurch gekennzeichnet, daß das Bedrucken als Teilschritt einer Produktions- und/oder Abfüllanlage erfolgt.

5. Druckplatten zur Durchführung des Verfahrens gemäß einem der Ansprüche 1 bis 4, dadurch gekennzeichnet, daß sie an beiden Rändern Reihen von Löchern aufweisen, die bezüglich Größe und Position eine Präzision im 10µ-Bereich aufweisen und die passergenauen Teilbilder bezogen auf die Reihen von Löchern an den Rändern im 10µ-Bereich genau positioniert sind, indem bereits die unbelichteten Druckplatten schon vor der Herstellung der Teilbilder mit Löchern an den Rändern versehen wurden, die bezüglich Größe und Position eine Präzision im 10µ-Bereich aufweisen.

## Claims

1. A process for printing non-absorbent materials, and especially round hollow bodies, in a letterpress process with multiple inks using multiple inking units with positionable printing plates mounted on the block cylinders, wherein the printing plates are mounted on the block cylinders by means of two lines of cylinder pins and matching lines of holes at two edges of the printing plates, characterized in that the lines of cylinder pins as well as the matching lines of holes along the edges of the printing plates with respect to size and position are of a precision within the 10 µ margin, and the accurate register partial images of the different printing plates are likewise accurately equally positioned relative to the lines holes along the edges within the 10 µ margin, with the lines of holes along the edges of the yet unexposed printing plates being provided already prior to fabrication of the partial images and serving for accurate positioning of the partial images as early as during the fabrication of same, wherein during fabrication of the partial images all the operational steps from first adjustment of the final drawing negative via fabrication of partial negatives to printing plate fabrication are effected in frames which likewise have lines of cylinder pins accurately positioned within the 10 µ margin and serve to accommodate all materials previously punched in accurate and matching fashion.

2. The process according to claim 1, characterized in that punching the printing plates and all the materials used for fabricating same is effected using a precision puncher.

3. The process according to claim 1 or 2, characterized in that the lines of cylinder pins on the block cylinders and on the frames are produced on electronically controlled machine tools.

4. The process according to anyone of claims 1 to 3, characterized in that said printing is effected as a partial step in a production and/or filling plant.

5. Printing plates for operating the process according to anyone of claims 1 to 4, characterized in that they comprise lines of holes along both edges which holes, with respect to size and position, are of a precision within the 10 µm margin, and the accurate register partial images are accurately positioned relative to the lines of holes along the edges within the 10 µm margin by having already provided the unexposed printing plates as early as prior to partial image fabrication with holes at the edges which, with respect to size and position, are of a precision within the 10 µ margin.

## Revendications

1. Procédé pour imprimer des supports non absorbants, notamment des corps creux cylindriques, dans un procédé typographique avec plusieurs encres, moyennant l'utilisation de plusieurs mécanismes encreurs équipés de plaques d'impression pouvant être mises en place et tendues sur des cylindres porte-plaques, les plaques d'impression étant tendues sur les cylindres porte-plaques à l'aide de deux rangées de tiges cylindriques et de rangées correspondantes de trous situés sur les deux bords des plaques d'impression,
caractérisé en ce qu'aussi bien les rangées de tiges cylindriques que les séries correspondantes de trous ménagés dans les bords des plaques d'impression présentent une précision de l'ordre de 10 µm du point de vue de leur grandeur et de leur position, et que les images partielles adaptées de façon précise des différentes plaques d'impression sont également positionnées par rapport aux rangées de trous situés sur les bords avec une précision dans la gamme de l'ordre de 10 µm,
les rangées de trous dans les bords des plaques d'impression non encore exposées étant ménagés déjà avant l'obtention des images partielles et étant utilisés déjà pendant l'obtention de ces images partielles pour leur positionnement exact,
et, lors de l'obtention de ces images partielles, toutes les étapes de travail allant du premier alignement du négatif du dessin seul, en passant par la fabrication des négatifs partiels, jusqu'à la fabrication de la plaque d'impression sont réalisées dans des cadres qui sont pourvus de rangées de tiges cylindriques lesquelles sont également positionnées avec une précision dans la gamme de 10 µm, et servent à recevoir tous les matériaux perforés au préalable d'une manière précise correspondante.

2. Procédé selon la revendication 1, caractérisé en ce que la perforation des plaques d'impression et de tous les matériaux utilisés pour leur fabrication s'effectue à l'aide d'un poinçon de précision.

3. Procédé selon la revendication 1 ou 2, caractérisé en ce que les rangées de tiges situées sur les cylindres porte-plaques et sur les cadres sont fabriquées au moyen de machines-outils à commande électronique.

4. Procédé selon l'une des revendications 1 à 3, caractérisé en ce que l'impression s'effectue en tant qu'étape partielle dans une installation de production et/ou de remplissage.

5. Plaques d'impression pour la mise en oeuvre du procédé selon l'une des revendications 1 à 4, caractérisées en ce qu'elles possèdent, sur leur deux bords, des rangées de trous, qui présentent une précision de l'ordre de 10 µm du point de vue de leur grandeur et de leur position, et les images partielles adaptées de façon précise sont positionnées avec une précision de l'ordre de 10 µm par rapport aux rangées de trous ménagées dans les bords, alors que déjà avant la fabrication des images partielles, on a déjà ménagé, dans les bords des plaques d'impression non exposées, des trous qui présentent une précision de l'ordre de 10 µm du point de vue de leur grandeur et de leur position.
